Europäisches Patentamt

European Patent Office

Office européen des brevets

(11) Veröffentlichungsnummer: **0 547 488 A1**

(12) **EUROPÄISCHE PATENTANMELDUNG**

(21) Anmeldenummer: **92120952.4**

(22) Anmeldetag: **09.12.92**

(51) Int. Cl.[5]: **G03F 7/42**

(30) Priorität: **16.12.91 DE 4141403**

(43) Veröffentlichungstag der Anmeldung:
**23.06.93 Patentblatt 93/25**

(84) Benannte Vertragsstaaten:
**CH DE FR GB LI**

(71) Anmelder: **HOECHST AKTIENGESELLSCHAFT**
**Postfach 80 03 20**
**W-6230 Frankfurt am Main 80(DE)**

(72) Erfinder: **Horn, Klaus, Dr.**
**Lessingstrasse 53**
**W-6238 Hofheim/Ts.(DE)**
Erfinder: **Lingnau, Jürgen, Dr.**
**Karolingerstrasse 10**
**W-6500 Mainz-Laubenheim(DE)**

(54) **Verfahren zum Entschichten von lichtvernetzten Photoresistschablonen.**

(57) Es wird ein Verfahren zum Entschichten von lichtvernetzten Photoresistschablonen mittels wäßrig-alkalischer Lösungen beschrieben, bei dem man die Photoresistschablone zuerst mit einer wäßrig-alkalischen Lösung höherer Konzentration und dann mit einer wäßrigalkalischen Lösung niedrigerer Konzentration behandelt, wobei das Konzentrationsverhältnis der beiden Lösungen so eingestellt wird, daß die Entschichtungsgeschwindigkeit in der ersten Lösung mindestens um den Faktor 1,5 größer ist als die in der zweiten Lösung. Durch das zweistufige Verfahren wird eine Ablösung der Resistschablone in Form kleinerer Flocken innerhalb kürzerer Zeit erreicht.

EP 0 547 488 A1

Die Erfindung betrifft ein Verfahren zum Entschichten von lichtvernetzten Photoresistschablonen mittels wäßrigalkalischer Lösungen.

Photoresistschablonen werden durch bildmäßiges Belichten von Photoresistschichten und Auswaschen der Nichtbildstellen mit einem geeigneten Lösemittel bzw. einer geeigneten Entwicklerlösung hergestellt. Negativ arbeitende Photoresists werden an den belichteten Stellen vernetzt oder polymerisiert und dadurch unlöslich, so daß die unbelichteten Stellen mit dem Entwickler ausgewaschen werden können. Die vernetzten bzw. polymerisierten Bildstellen weisen im allgemeinen eine hohe Resistenz gegenüber Verarbeitungschemikalien, wie Ätzlösungen oder galvanischen Bädern auf. Sie haben jedoch den Nachteil, daß sie sich nach dem Ätzen oder Galvanisieren schwieriger entfernen lassen als positiv arbeitende Schichten, bei denen die Löslichkeit der Bildstellen nicht durch Vernetzung vermindert wird. Zum Entschichten bzw. Strippen dieser Schichtbereiche wird zumeist wäßrige Kali- oder Natronlauge eingesetzt. Dabei werden die Schichtbestandteile in der Regel nicht aufgelöst, sondern in Form von Flocken oder Fladen dispergiert. Wenn Photoresists eingesetzt werden, die eine besonders hohe ammoniakalische Ätzresistenz oder eine hohe Resistenz gegenüber alkalischen Bädern, z. B. galvanischen Goldbädern, aufweisen, erfolgt die Entschichtung besonders langsam und unter Bildung von relativ groben Fladen. Größere Fladen haben den Nachteil, daß sie sich schwerer aus den engen Kanälen entfernen lassen, die beim Galvanisieren zwischen Leiterzügen entstehen und die häufig noch durch Überhänge von galvanisch abgeschiedenem Metall oberhalb der Resistlinien zusätzlich verengt werden.

Man hat auch zur Entschichtung organische Lösemittel, insbesondere Methylenchlorid eingesetzt, in dem die Schichtbestandteile mindestens teilweise löslich sind. Eine kombinierte Behandlung mit Methylenchlorid und Kalilauge ist in der DE-A 22 57 270 beschrieben. Wegen des hohen Dampfdrucks und der Toxizität des Methylenchlorids werden derartige Mittel heute praktisch nicht mehr eingesetzt.

In der EP-A 212 556 wird eine Entschichterlösung für lichtgehärtete Photoresistschichten beschrieben, die aus einer wäßrigen Lösung einer quaternären Ammoniumbase, ggf. in Kombination mit Alkalihydroxid, besteht. Diese Lösung bewirkt die Bildung kleinerer Resistflocken. Bei ihrer Anwendung geht sogar ein gewisser Teil der Schichtbestandteile in Lösung. Dies hat den Nachteil, daß einesteils die Entschichterlösung rascher verbraucht wird und andererseits bei der Entsorgung der verbrauchten Lösung ein höherer chemischer und/oder biologischer Sauerstoffbedarf (CSB/BSB) vorliegt, wie es in der EP-A 254 550 beschrieben ist.

In der Praxis wird allgemein mit 1 bis 5 %iger wäßriger Kali- oder Natronlauge bei Temperaturen im Bereich um 40 bis 60 °C entschichtet. Dabei wirken sich Temperatur und Konzentration in der Weise aus, daß bei hoher Alkalikonzentration eine höhere Strippgeschwindigkeit und größere Fladen, bei hoher Temperatur eine höhere Strippgeschwindigkeit und kleinere Fladen erzielt werden. Für die Temperatur- und Konzentrationsbereiche gelten jedoch bestimmte Obergrenzen, bei deren Überschreiten andere Nachteile auftreten. So wird bei hohen Alkalikonzentrationen und hohen Temperaturen Glanzzinn und das Zinn aus Blei/Zinn-Legierung durch Stannatbildung aufgelöst. Das Ergebnis sind Dünnstellen bei zinnhaltigen Metallschichten oder ein verändertes Umschmelzverhalten durch Verschiebung des Pb/Sn-Verhältnisses.

Aufgabe der Erfindung war es daher, ein Entschichtungsverfahren für lichtvernetzte Photoresistschablonen vorzuschlagen, bei dem die vernetzte Schicht rasch und rückstandsfrei unter Bildung von relativ kleinen Flocken von der Unterlage entfernt wird. Das Verfahren sollte insbesondere bei Photoresistschablonen mit hoher ammoniakalischer Ätzresistenz und hoher Galvanoresistenz wirksam sein und keine umweltschädigenden organischen Lösemittel erfordern.

Bei der Lösung dieser Aufgabe wurde gefunden, daß die Größe der Fladen und die Strippgeschwindigkeit unterschiedlichen Mechanismen folgen. Für die Strippgeschwindigkeit ist die Alkalikonzentration an der Grenzfläche zwischen dem Metallsubstrat - normalerweise aus Kupfer - und der Photoresistschicht wesentlich, um eine Ablösung an dieser Grenzfläche zu bewirken. Die Fladengröße wird durch die Quellung der partiell neutralisierten Schicht bestimmt, ist also ein Volumeneffekt. Die Quellung nimmt mit der Alkalikonzentration zunächst bis zu einem Optimum zu und wird bei höheren Konzentrationen wieder zurückgedrängt. Es ist daher im allgemeinen erwünscht, in der Schicht eine geringere Alkalikonzentration zu haben als an der Grenzfläche.

Erfindungsgemäß wird ein Verfahren zum Entschichten von lichtvernetzten Photoresistschablonen mittels wäßrigalkalischen Lösungen vorgeschlagen, das darin besteht, daß man die Photoresistschablone zuerst mit einer wäßrigalkalischen Lösung höherer Konzentration und dann mit einer wäßrig-alkalischen Lösung niedrigerer Konzentration behandelt, wobei das Konzentrationsverhältnis der beiden Lösungen so eingestellt wird, daß die Entschichtungsgeschwindigkeit in der ersten Lösung mindestens um den Faktor 1,5 größer ist als die in der zweiten Lösung.

Der Begriff "Entschichtungs-" bzw. "Strippgeschwindigkeit", wie er im Rahmen der vorliegenden Erfindung gebraucht wird, beschreibt eine relative Größe. Sie wird unter jeweils festzulegenden Bedingungen von Temperatur und Behandlungsvorrichtung bei gleicher Resistzusammensetzung im gleichen Behandlungsstadium und gleicher Schichtdicke ermittelt. Dabei wird die Zeit bis zur vollständigen Entschichtung festgestellt.

Das erforderliche Verhältnis der Entschichtungsgeschwindigkeiten in den verschiedenen Lösungen erreicht man im allgemeinen dadurch, daß die Alkalikonzentration der ersten Lösung mindestens 1,5 mal so hoch ist wie die der zweiten Lösung.

Als Alkalien werden bevorzugt Alkalimetallhydroxide eingesetzt; von ihnen werden Natrium- und Kaliumhydroxid bevorzugt. Diese können, insbesondere in der zweiten Lösung, mit Basen mit größerem Kationenradius, also höheren Alkalimetallhydroxiden oder quaternären Ammoniumbasen kombiniert werden. In der ersten oder zweiten, bevorzugt in der zweiten Lösung können anstelle von Hydroxiden oder zusätzlich zu diesen auch Puffergemische, z. B. Alkalimetasilikate; eingesetzt werden. Grundsätzlich können auch quaternäre Ammoniumbasen in der ersten oder zweiten Stufe als einzige alkalische Bestandteile eingesetzt werden.

Die Alkalikonzentration der ersten Lösung liegt im allgemeinen im Bereich von 1,5 bis 7, vorzugsweise von 2 bis 4 Gew.-%. Die zweite Lösung enthält im allgemeinen 0,3 bis 2, bevorzugt 0,5 bis 1,5 % Base. Die Temperatur der Lösungen liegt allgemein zwischen Raumtemperatur und 80 °C, wobei erhöhte Temperaturen bevorzugt werden. Ein bevorzugter Temperaturbereich liegt zwischen 40 und 60 °C. Die Lösungen können gleiche oder unterschiedliche Temperaturen haben. Wenn die Temperaturen unterschiedlich sind, ist vorzugsweise die der zweiten Lösung höher als die der ersten.

Die Dauer der Einwirkung der beiden Lösungen kann von Fall zu Fall so variiert werden, daß eine möglichst kurze Gesamteinwirkungszeit erreicht wird. Die Größe der Fladen bzw. Flocken ist über weite Bereiche von dem Verhältnis der Behandlungszeiten unabhängig. Die Einwirkungszeit der ersten Lösung sollte so bemessen sein, daß darin noch keine Ablösung von Schichtteilen erfolgt. Im allgemeinen liegt die Einwirkungszeit der ersten Lösung je nach Schichtdicke und Alkalikonzentration zwischen etwa 10 und 150, vorzugsweise zwischen 20 und 100 Sekunden. Die zweite Lösung wird dann so lange einwirken gelassen, bis die Resistschablone restlos entfernt ist. Das erfordert je nach der Dauer der ersten Behandlung etwa 10 bis 250, vorzugsweise 10 bis 100 Sekunden.

Den Behandlungslösungen können außer den oben erwähnten basischen Zusätzen noch weitere Substanzen zugesetzt werden, die eine Bildung von kleineren Fladen bzw. Flocken begünstigen. Hierfür sind z. B. organische Lösemittel, insbesondere mit Wasser mischbare Lösemittel, z. B. Glykolether, insbesondere niedere Monoalkylether; Alkohole, Glykole, Oligoglykole oder deren Monoester geeignet. Das Lösemittel sollte bevorzugt einen Flammpunkt oberhalb der Stripptemperatur haben. Im allgemeinen werden Mengen bis zu 10 %, bevorzugt bis zu 5 % zugesetzt. Netzmittel in kleinen Mengen können ebenfalls zugesetzt werden. Auch die oben erwähnten quaternären Ammoniumbasen, z. B. Tetramethylammoniumhydroxid, haben eine günstige Wirkung. Gegebenenfalls können den Lösungen auch kleine Mengen Antischaummittel zugesetzt werden. Die Einwirkung der Behandlungslösungen kann im Ruhezustand, z. B. durch Tauchen, erfolgen. Ihre Wirkung wird durch Bewegung wesentlich unterstützt, so daß vorteilhaft die Resistschablonen mit einer bewegten Lösung kontaktiert werden. Mit besonderem Vorteil erfolgt die Behandlung in einer üblichen Sprühbehandlungsvorrichtung.

Dies ist besonders bei der zweiten Behandlungsstufe von Vorteil, in der es darauf ankommt, die Schichtteile auch aus schwer zugänglichen Stellen zu entfernen. Gegebenenfalls kann in einer weiteren Behandlungsstufe die Oberfläche der bereits weitgehend oder vollständig entschichteten Platte in einer Hochdrucksprühanlage nochmals mit weiter verdünnter Entschichtungslösung behandelt werden.

Das erfindungsgemäße Verfahren wird mit negativ arbeitenden, also lichthärtbaren Resistschichten durchgeführt. Als lichthärtbare Schichten sind z. B. solche auf Basis von Polyvinylcinnamat, cyclisiertem Kautschuk, organischen Aziden, Chalkonen und allylgruppen enthaltenden Polymeren geeignet. Mit besonderem Vorteil läßt sich das Verfahren mit photopolymerisierbaren Materialien durchführen, insbesondere solchen, die sich mit wäßrig-alkalischen Lösungen entwickeln lassen. Diese enthalten als wesentliche Bestandteile ihrer Aufzeichnungsschicht eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, Lichtempfindlichkeitsregler, sensitometrische Regler, Farbstoffe und farblose oder Farbpigmente enthalten.

Für die Zwecke der Erfindung geeignete photopolymerisierbare Monomere sind bekannt und z. B. in den US-A 2 760 863 und 3 060 023 beschrieben. Bevorzugte Beispiele sind Acryl- und Methacrylsäureester, wie Polyethylenglykoldimethacrylat, Acrylate und Methacrylate von Trimethylolethan, Trimethylolpropan und Pentaerythrit und von mehrwertigen alicyclischen Alkoholen. Mit Vorteil werden auch Umsetzungs-

3

produkte von Diisocyanaten mit Partialestern mehrwertiger Alkohole eingesetzt. Derartige Monomere sind in den DE-A 20 64 079, 23 61 041 und 28 22 190 beschrieben.

Als Bindemittel werden vorzugsweise solche verwendet, die in wäßrig-alkalischen Lösungen löslich oder mindestens quellbar sind. Als Beispiele hierfür seien genannt: Maleinatharze, Polymerisate aus N-(p-Tolylsulfonyl)carbaminsäure-(ß-methacryloyloxy-ethyl)ester und Mischpolymerisate dieser und ähnlicher Monomerer mit anderen Monomeren sowie styrol-Maleinsäureanhydrid-Mischpolymerisate. Methylmethacrylat-Methacrylsäure-Mischpolymerisate und Mischpolymerisate aus Methacrylsäure, Alkyl-(meth)acrylaten und Methylmethacrylat und/oder Styrol, Acrylnitril u. a., wie sie in den DE-A 20 64 080 und 23 63 806 sowie den EP-A 173 057 und 330 059 beschrieben sind, werden besonders bevorzugt.

Die Schichtdicke der zu entschichtenden Photoresistschichten liegt im allgemeinen im Bereich von 5 bis 100, vorzugsweise von 20 bis 50 $\mu$m. Bei diesen Schichtdicken handelt es sich im allgemeinen um Photoresistschichten, die nach dem bekannten Trockenphotoresistverfahren durch Laminieren auf die zu bearbeitende Unterlage aufgebracht werden. Diese besteht zumeist aus einer mit Kupferfolie kaschierten Isolierstoffplatte. Nach dem Belichten und Entwickeln der Photoresistschicht wird in üblicher Weise das freigelegte Metall geätzt oder an diesen Stellen Metall galvanisch abgeschiedenn. Besonders im letzteren Fall kann es vorkommen, daß sich die abgeschiedenen Metallinien oder -elemente bei Erreichen der Schichtdicke der Resistschicht seitlich verbreitern und dadurch Teile der Resistschablone überdecken. In diesem Fall ist es besonders schwierig, die Resistschablone rückstandsfrei zu entfernen. Es spielt dabei eine erhebliche Rolle, ob der gehärtete Resist in Form von kleineren oder größeren Flocken abgelöst wird. Bei der Bildung von möglichst kleinen Flocken ist es wesentlich leichter, Resistreste auch unterhalb von solchen Metallüberhängen zu entfernen.

Durch das erfindungsgemäße Verfahren wird eine raschere Entschichtung in Verbindung mit einer Bildung kleinerer Flocken, als es bei einem einstufigen Verfahren möglich war, erreicht. Obwohl keine sicheren Kenntnisse über die Ursachen für dieses Ergebnis vorliegen, wird angenommen, daß in der ersten Stufe mit der konzentrierteren Base ein rasches Durchdringen der Resistschicht bis zur Grenzfläche und eine Lockerung der Haftung an dieser Grenzfläche bewirkt wird. In der zweiten Stufe tritt dann der Zerfall der Resistschablone ein, der in Gegenwart des verdünnteren Alkalis zu feineren Flocken erfolgt.

Die folgenden Beispiele erläutern die Vorteile des erfindungsgemäßen Verfahrens. Wenn nichts anderes angegeben ist, sind Prozentzahlen und Mengenverhältnisse in Gewichtseinheiten zu verstehen. Die Mengen sind in Gewichtsteilen (Gt) angegeben.

Beispiel 1

Auf eine biaxial verstreckte und thermofixierte Polyethylenterephthalatfolie von 25 $\mu$m Stärke wurde eine Lösung folgender Zusammensetzung so aufgeschleudert, daß nach dem Trocknen ein Schichtgewicht von 43 g/m$^2$ erhalten wurde:

6,3 Gt eines Copolymeren aus 20 Gew.-% Methacrylsäure, 50 Gew.-% Methylmethacrylat und 30 Gew.-% 2-Ethylhexylacrylat,

1,85 Gt des Diurethans aus 2 mol Hydroxyethylmethacrylat und 1 mol 2,2,4-Trimethylhexamethylendiisocyanat,

1,11 Gt des Umsetzungsprodukts aus 1 mol Hydroxyethylmethacrylat, 6 mol Ethylenoxid und 1 mol n-Butylisocyanat,

0,74 Gt Trimethylolpropan-tris-acryloyloxyethylether,

0,035 Gt 9-Phenylacridin,

0,081 Gt Leukokristallviolett,

0,01 Gt 1',3',3'-Trimethyl-6-nitro-8-methoxyspiro[2H-1-benzopyran-2,2'-indolin],

0,005 Gt Viktoriareinblau FGA und

0,01 Gt Tribrommethyl-phenylsulfon in

9,5 Gt Ethanol und

9,5 Gt Butanon.

Die so hergestellte Trockenresistfolie wurde in einer handelsüblichen Laminiervorrichtung bei 115 °C mit einer Durchlaufgeschwindigkeit von 1,5 m/Minute und einem Walzenanpreßdruck von 3 bar auf gebürstete kupferkaschierte Phenolharzplatten laminiert. Die Photoresistschicht wurde dann unter einer Vorlage mit 50 mJ/cm$^2$ belichtet und 15 Minuten bei Raumtemperatur gelagert. Dann wurde die Trägerfolie abgezogen und die Schicht bei einer Durchlaufgeschwindigkeit von 0,6 m/Minute mit 1 %iger Natriumcarbonatlösung bei 28 °C und einem Sprühdruck von 2 bar in einem handelsüblichen Sprühentwicklungsgerät entwickelt und getrocknet. Die entwickelten Platten wurden in einem handelsüblichen Kupferbad bis zu einer Dicke von 35 $\mu$m und einem Pb/Sn-Bad zu einer Dicke von 10 $\mu$m galvanisiert. Die gehärtete

Photoresistschablone wurde dann zuerst in 3 %iger wäßriger Natronlauge bei 50 °C und dann in 1 %iger Natronlauge ebenfalls bei 50 °C entschichtet. Die Dauer der ersten Stufe ist in der folgenden Tabelle I angegeben; in der zweiten Stufe wurde stets bis zur vollständigen Entfernung der Resistschablone behandelt. In der letzten Spalte ist die Fladengröße angegeben. Sie ist auf einer Skala von 0 bis 6 ausgedrückt, wobei

```
0 vollständige Auflösung,
1 Fladen bis zu 1          mm²,
2 "      von 1 bis 3       ",
3 "      von 3 bis 10      ",
4 "      von 10 bis 30     ",
5 "      von 30 bis 60     ",
6 "      von mindestens 60 "
```

bedeutet. Eine Suspension wurde einem bestimmten Skalenwert zugeordnet, wenn die Mehrzahl der Fladen in dem angegebenen Größenbereich lag.

Tabelle I

| Versuch Nr. | Behandlungsdauer | | Fladengröße |
|---|---|---|---|
| | 1. Stufe 3 % NaOH bei 50 °C | 2. Stufe 1 % NaOH bei 50 °C | |
| 1 | 49 s | - | 5-6 |
| 2 | 0 | 117 s | 2-3 |
| 3 | 10 | 95 s | 2-3 |
| 4 | 20 | 68 s | 2-3 |
| 5 | 30 | 40 s | 3 |
| 6 | 35 | 27 s | 3 |
| 7 | 35 | 85 s [1] | 0-1 |

[1] in 0,5 %iger NaOH

Beispiel 2

Wie in Beispiel 1 beschrieben, wurde eine Trockenresistfolie durch Beschichten mit einer Lösung von
6,3 Gt eines Polymeren aus 20 Gew.-% Methacrylsäure, 40 Gew.-% Methylmethacrylat,
1,85 Gt des in Beispiel 1 angegebenen Diurethans,
1,11 Gt des in Beispiel 1 angegebenen Monomethacrylats,
0,74 Gt Trimethylolpropan-tris-acryloyloxyethylether,
0,035 Gt 9-Phenylacridin,
0,081 Gt Leukokristallviolett,
0,01 Gt 1',3',3'-Trimethyl-6-nitro-8-methoxyspiro[2H-1-benzopyran-2,2'-indolin],
0,005 Gt Viktoriareinblau FGA und
0,01 Gt Tribrommethylphenylsulfon in
9,5 Gt Ethanol und
9,5 Gt Butanon
hergestellt. Sie wurde wie dort angegeben laminiert, belichtet und entwickelt. Auf den freigelegten Kupferzügen wurde, wie in Beispiel 1 beschrieben, Kupfer und Blei/Zinn-Legierung galvanisch abgeschieden. Die Photoresistschablone wurde erfindungsgemäß in zwei Stufen entschichtet. Die Ergebnisse zeigt Tabelle II.

Beispiele 3 und 3a

Wie in den vorhergehenden Beispielen beschrieben, wurde eine Photoresistschablone durch Beschichten, Laminieren, Belichten und Entwickeln hergestellt und als Galvanoresist verwendet. Die Beschichtungslösung hatte die folgende Zusammensetzung:

6,5 Gt eines Terpolymerisats aus 60 Gt n-Hexylmethacrylat, 30 Gt Methacrylsäure und 10 Gt Styrol ($\overline{M}_w$ 128.000, Säurezahl 195) hergestellt durch Polymerisation in der Masse,

8,8 Gt eines durch Umsetzung von 1 mol Triethylenglykol, 2 mol 2,2,4-Trimethyl-hexamethylendiisocyanat und 2 mol Hydroxyethylmethacrylat hergestellten polymerisierbaren Diurethans,

0,25 Gt 9-Phenylacridin und

0,025 Gt eines blauen Farbstoffs, erhalten durch Kuppeln von 2,4-Dinitro-6-chlorbenzoldiazoniumsalz mit 2-Methoxy-5-acetylamino-N,N-diethylanilin, in

15 Gt Butanon und

15 Gt Ethanol.

Die Ergebnisse der Entschichtungsversuche zeigt Tabelle II.

Beispiele 4 und 4a

Es wurde wie in Beispiel 3 gearbeitet. Die Beschichtungslösung hatte die gleiche Zusammensetzung wie in Beispiel 1, jedoch wurde hier ein Polymeres aus 25 Gew.-% Methacrylsäure, 33 Gew.-% Methylmethacrylat, 5 Gew.-% Styrol, 22 Gew.-% 2-Ethyl-hexylacrylat und 15 Gew.-% Butylacrylat als Bindemittel eingesetzt. Das Schichtgewicht der Photoresistschicht betrug nach dem Trocknen 75 g/m$^2$. Die Ergebnisse zeigt Tabelle II. Alle Lösungen wurden bei 50 °C einwirken gelassen.

Tabelle II

| Beispiel Nr. | 1. Stufe | | | 2. Stufe | |
|---|---|---|---|---|---|
| | Zeit (s) | Konzentration | Zeit (s) | Konzentration | Fladengröße |
| 2 | 10 | 3 % NaOH | 45 | 1 % NaOH | 2 - 3 |
| | 20 | " | 19 | " | 2 - 3 |
| | 30 | " | 5 | " | 2 - 3 |
| | 45 | " | 0 | " | 5 |
| 3 | 10 | 5 % KOH | 400 | 1 % KOH | 4 - 5 |
| | 20 | " | 245 | " | 4 |
| | 30 | " | 170 | " | 3 - 4 |
| | 57 | " | 0 | --- | 5 - 6 |
| 3a | 10 | 5 % NaOH | 283 | 1 % NaOH | 5 |
| | 20 | " | 213 | " | 4 - 5 |
| | 30 | " | 147 | " | 4 - 5 |
| | 79 | " | 0 | --- | 5 |
| 4 | 60 | 3 % NaOH | 220 | 1 % NaOH | 2 - 3 |
| | 120 | " | 50 | " | 2 - 3 |
| | 180 | " | 5 | " | 5 |
| | 157 | " | 0 | --- | 5 |
| 4a | 30 | 3 % NaOH | 33 | [1] | 2 |
| | 30 | " | 69 | [2] | 2 |
| | 30 | " | 60 | [3] | 2 - 3 |
| | 30 | " | 138 | [4] | 2 |

[1] handelsübliche wäßrige Stripperlösung
(ca. 2,5 % aliphat. Hydroxyamine und quatern. Ammoniumbasen, ca. 0,2 % Glykolether)
[2] wie [1], auf das 2,5-fache verdünnt
[3] 1 % NaOH, 0,5 % Oligoglykolether,
0,001 % nichtionogenes Netzmittel
[4] wie [3] auf das Doppelte verdünnt

**Patentansprüche**

1. Verfahren zum Entschichten von lichtvernetzten Photoresistschablonen mittels wäßrig-alkalischer Lösungen, dadurch gekennzeichnet, daß man die Photoresistschablone zuerst mit einer wäßrigalkalischen Lösung höherer Konzentration und dann mit einer wäßrig-alkalischen Lösung niedrigerer Konzentration behandelt, wobei das Konzentrationsverhältnis der beiden Lösungen so eingestellt wird, daß die Entschichtungsgeschwindigkeit in der ersten Lösung mindestens um den Faktor 1,5 größer ist als die in der zweiten Lösung.

2. Verfahren nach Anspruch 1, dadurch gekennzeichnet, daß die Alkalikonzentration der ersten Lösung mindestens um den Faktor 1,5 höher ist als die der zweiten Lösung.

3. Verfahren nach Anspruch 1, dadurch gekennzeichnet, daß als Alkali ein Alkalimetallhydroxid eingesetzt wird.

4. Verfahren nach Anspruch 1, dadurch gekennzeichnet, daß das Entschichten bei erhöhter Temperatur durchgeführt wird.

5. Verfahren nach Anspruch 1, dadurch gekennzeichnet, daß man die Einwirkung der ersten Lösung auf eine Zeit begrenzt, in der noch keine Ablösung der Resistschablone erfolgt.

6.  Verfahren nach Anspruch 1, dadurch gekennzeichnet, daß man der zweiten Lösung ein Tetraalkylammoniumhydroxid oder ein Alkalimetallhydroxid höherer Ordnungszahl zusetzt.

7.  Verfahren nach Anspruch 4, dadurch gekennzeichnet, daß die Temperatur der zweiten Lösung höher ist als die der ersten.

8.  Verfahren nach Anspruch 3, dadurch gekennzeichnet, daß als Alkalimetallhydroxid Natrium- oder Kalium-hydroxid eingesetzt wird.

9.  Verfahren nach Anspruch 2 oder 3, dadurch gekennzeichnet, daß die erste Lösung 1,5 bis 7 Gew.-% Alkali enthält.

10. Verfahren nach Anspruch 2 oder 3, dadurch gekennzeichnet, daß die zweite Lösung 0,3 bis 2 Gew.-% Alkali enthält.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | EP-A-0 267 437 (SCHERING AG) <br> * das ganze Dokument * <br><br> --- | 1-10 | G03F7/42 |
| A | EP-A-0 189 752 (MERCK PATENT GMBH) <br><br> ----- | | |

RECHERCHIERTE SACHGEBIETE (Int. Cl.5 )

G03F

Der vorliegende Recherchenbericht wurde für alle Patentansprüche erstellt

| Recherchenort | Abschlußdatum der Recherche | Prüfer |
|---|---|---|
| DEN HAAG | 08 FEBRUAR 1993 | HAENISCH U.P. |

EPO FORM 1503 03.82 (P0403)